# EUROPEAN PATENT SPECIFICATION

(11) **EP 1 289 134 B1**
(45) Date of publication and mention of the grant of the patent: **25.10.2006**
(21) Application number: 02017721.8
(22) Date of filing: 08.08.2002
(51) Int. Cl.: H03H 9/02

(54) **Surface acoustic wave device**
Akustische Oberflächenwellenvorrichtung
Dispositif à ondes acoustiques de surface

(30) Priority: 09.08.2001 JP 2001242757; 27.05.2002 JP 2002152018
(43) Date of publication of application: 05.03.2003
(73) Proprietor: SEIKO EPSON CORPORATION, Shinjuku-ku, Tokyo 163-0811 (JP)
(72) Inventor: Yamazaki, Takashi, Suwa-shi, Nagano-ken 392-8502 (JP); Iizawa, Keigo, Suwa-shi, Nagano-ken 392-8502 (JP); Kanna, Shigeo, Suwa-shi, Nagano-ken 392-8502 (JP)
(74) Representative: Hoffmann, Eckart

(56) References cited:
- EP-A- 0 738 039
- US-A- 5 895 996
- PATENT ABSTRACTS OF JAPAN vol. 014, no. 576 (E-1016), 21 December 1990 (1990-12-21) & JP 02 250413 A (MURATA MFG CO LTD), 8 October 1990 (1990-10-08)
- PATENT ABSTRACTS OF JAPAN vol. 014, no. 576 (E-1016), 21 December 1990 (1990-12-21) & JP 02 250412 A (MURATA MFG CO LTD), 8 October 1990 (1990-10-08)

## Description

The present invention relates to a surface acoustic wave (SAW) device designed to reduce the fluctuation of frequency to temperature change by using an in-plane rotated ST cut quartz crystal plate, rotated around the Z'- axis (called in-plane Z'-rotated ST cut quartz crystal plate hereafter).

Surface acoustic wave devices in which IDT (Interdigital Transducer) electrodes are provided on the principal surface of a piezoelectric flat plate formed by a quartz crystal sheet and multiple reflectors are provided at both ends of the IDT electrodes to stably oscillate a high frequency (sometimes called SAW resonator hereafter) have been known before.

Among these known resonators is an ST cut SAW resonator in which an ST cut quartz crystal plate is used as a piezo-electric flat plate for the purpose of reducing the fluctuation of frequency to temperature change and the X-axis direction of the ST cut quartz crystal plate is taken as the propagation direction of the acoustic wave.

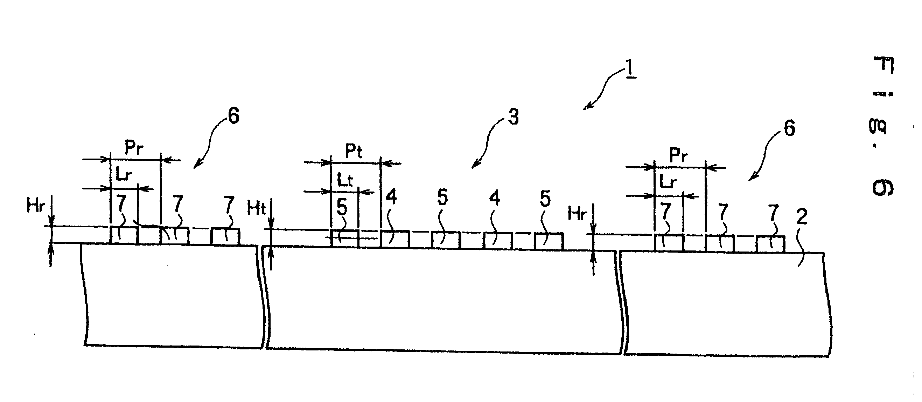

Fig. 6 is a schematic sectional view showing the structure of an ST cut SAW resonator.

As shown in Fig. 6, the resonator **1** has an ST cut quartz crystal plate **2** as the substrate, and IDT electrodes **3** are provided on the principal surface of the substrate. Comb teeth-like anodes **4** and cathodes **5** are alternately arranged in the IDT electrodes **3**, and a surface acoustic wave is excited due to the piezoelectric effect of the quartz crystal plate by applying a high-frequency electric field between the anodes **4** and cathodes **5**.

Multiple reflectors **6** are provided on both sides of the IDT electrodes **3** for the purpose of reflecting the surface acoustic wave, and the reflection of the surface acoustic wave emitted from the IDT electrodes **3** is performed by multiple short-circuit electrodes **7** formed in the reflectors **6**. The anodes **4** and cathodes **5** in the IDT electrodes **3** and the short-circuit electrodes **7** in the reflectors **6** are arrayed in the X-axis direction of the crystal plate **2**, and the reflection of the surface acoustic wave in the short-circuit electrodes **7** is performed at positions of both edges of the electrodes.

In the resonator **1** thus constructed, as shown in Fig. 6, the width and the pitch of the anodes **4** and cathodes **5** in the IDT electrodes **3** are defined as Lₜ, Pₜ and the width and the pitch of the short-circuit electrodes **7** in the reflectors **6** are defined as Lᵣ, Pᵣ. The thickness of the anodes **4** and cathodes **5** is defined as Hₜ and the thickness of the short-circuit electrodes **7** is defined as Hᵣ.

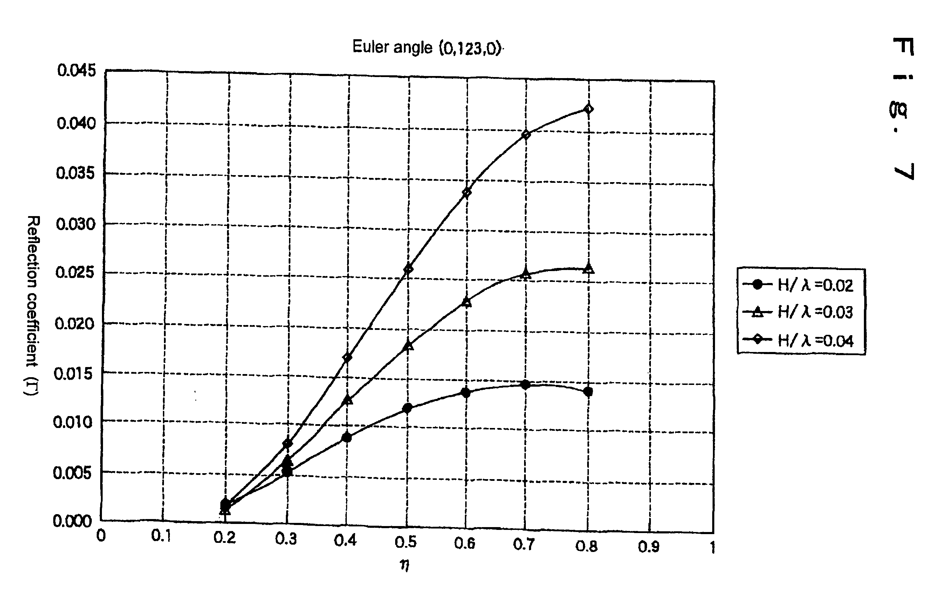

Fig. 7 is a graph showing the reflection coefficient per short-circuit electrode of the resonator **1**.

In the resonator **1**, if the reflection coefficient of a surface acoustic wave can be increased, it is possible to reduce the number of reflectors **6** and to miniaturize the resonator itself. Fig. 7 shows the value of Lₜ/Pₜ (= Lᵣ/Pᵣ, called η hereafter) on the horizontal axis and shows the reflection coefficient per short-circuit electrode on the vertical axis and shows how the reflection coefficient changes with the value of the Hₜ/2Pₜ (≅ Hᵣ/2Pᵣ).

When the reflection coefficient is considered, Hₜ/2Pₜ and Hᵣ/2Pᵣ can be regarded as having nearly the same value. 2Pₜ and 2Pᵣ have nearly the same value, so 2Pₜ and 2Pᵣ are defined as λ. Therefore, in the present embodiment, Hₜ/2Pₜ and Hᵣ/2Pᵣ are not distinguished and are treated as same value, i. e., H/λ.

As shown in Fig. 7, for the resonator **1**, it is known that the reflection coefficient increases with an increase in η and the higher H/λ, the higher the increase of the reflection coefficient with an increase of η (JP-A-2-260908).

In the resonator **1**, the thickness (H) of the anodes **4**, cathodes **5** and short-circuit electrodes **7** is commonly set up so that H/λ becomes about 0.03 from a viewpoint of obtaining objective temperature characteristics. And η is set to 0.5 so that a relation of Pₜ = 2Lₜ is established.

In the SAW resonator, a quartz crystal plate cut from the in-plane rotated ST cut quartz crystal plate, rotated around the Z'-axis is sometimes used for the purpose of further reducing the frequency change caused by a temperature change. However, the relationship between η, H/λ and the reflection coefficient have not yet been verified with such in-plane Z'-rotated ST cut quartz crystal plate.

When the inventors studied the in-plane Z'-rotated ST cut quartz crystal plate, they confirmed that it has characteristics quite different from those of a conventional ST cut quartz crystal plate, and the rules true for the conventional ST cut quartz crystal plate, namely that the reflection coefficient is increased by increasing η and H/λ, do not apply. Therefore, a problem arises that the reflection coefficient cannot be fully obtained even if the rules of the conventional ST cut quartz crystal plate are applied to the in-plane Z'-rotated ST cut quartz crystal plate to increase η and H/λ.

US 5,895,996 discloses an SAW device. It utilizes elastic surface waves in which the Q value is high. The SAW device is manufactured from a piezoelectric crystal in which an angle θ is 25 °- 45 ° and an angle ψ is 40 °- 47 °. The frequency-temperature-characteristics is Taylor developed around a temperature of 20 °C with a cubic polynome.

JP02250412 discloses a SAW device with improved reflection coefficient. A value smaller than 0,45 for the ratio of electrode width to electrode pitch is said to be advantageous.

The present invention addresses the above problem and has the objective of providing a surface acoustic wave device which enables increasing the reflection coefficient when the in-plane Z'-rotated ST cut quartz crystal plate is used.

The present invention is based on the inventors' various studies and the knowledge that the characteristics of the ST cut quartz crystal plate in a plane rotated around the Z'-axis differ from the characteristics of a conventional ST cut quartz crystal plate.

Namely, the surface acoustic wave device relating to the present invention is so constructed that it has one or more pairs of IDT electrodes for exciting a Rayleigh wave, which are arranged on the principal surface of the in-plane Z'-rotated ST cut quartz crystal plate and exist at an Euler angle (0,

113 - 135, ±(40 - 49)) and either or both of the ratio Lₜ/Pₜ of width Lₜ of the IDT electrodes to pitch Pₜ of the IDT electrodes and the ratio Lᵣ/Pᵣ of width Lᵣ of the reflector to pitch Pᵣ of the reflectors are less than 0.5.

It is desirable that either or both of Lₜ/Pₜ and Lᵣ/Pᵣ is 0.32 ± 0.1, and it is further desirable that, with the thickness of the IDT electrodes denoted as Hₜ and the thickness of the reflectors denoted as Hᵣ, either or both of Hₜ/2Pₜ and Hᵣ/2Pᵣ are 0.06 ± 0.01.

Thus, if the in-plane Z'-rotated ST cut quartz crystal plate is applied to the surface acoustic wave device, it is different from a surface acoustic wave device to which a conventional ST cut quartz crystal plate is applied, in that if Lₜ/Pₜ in the IDT electrodes is decreased, the reflection coefficient is improved.

More specifically, it is desirable that Lₜ/Pₜ be less than the value of Lₜ/Pₜ (0.5) generally applied to a conventional surface acoustic wave device having a conventional ST cut quartz crystal plate. If Lₜ/Pₜ is set to less than 0.5, it enables improving the reflection coefficient and to achieve the miniaturization of the device itself.

If Lᵣ/Pᵣ of reflectors provided adjacent to the IDT electrodes is also set to less than 0.5 like Lₜ/Pₜ, this enables a further improvement in the reflection coefficient and promotes the miniaturization of the device itself. Thus, if both Lₜ/Pₜ and Lᵣ/Pᵣ are set to less than 0.5, the reflection coefficient can be substantially improved, but even if either one of Lₜ/Pₜ and Lᵣ/Pᵣ is set to less than 0.5 there is an improvement in the reflection coefficient.

According to the investigations of the inventors, if either one or both of Lₜ/Pₜ and Lᵣ/Pᵣ are set to 0.32 ± 0.1 and either one or both of Hₜ/2Pₜ and Hᵣ/2Pᵣ are further set to 0.06 ± 0.01, it enables further improving the reflection coefficient and achieving the miniaturization of device itself.

A preferred embodiment of the present invention is described in detail hereafter, with reference to the drawings below.
- Fig. 1: A front view of one embodiment of an SAW device according to the present invention.
- Fig. 2: A schematic sectional view of the device in Fig. 1.
- Fig. 3: An illustrative diagram of the in-plane Z'-rotated ST cut quartz crystal plate.
- Fig. 4: Graphs for comparing the reflection coefficient of the SAW device of this embodiment and that of a conventional SAW device.
- Fig. 5: The relationship of reflection coefficient versus H/λ in the SAW device of the present embodiment, wherein Fig. 5(1) shows a table of calculation results, and Fig. 5(2) is graph based on the calculation results in Fig. 5(1).
- Fig. 6: A schematic sectional view showing the structure of an ST cut SAW resonator.
- Fig. 7: Graphs showing the reflection coefficient per short-circuit electrode of an ST cut SAW resonator.

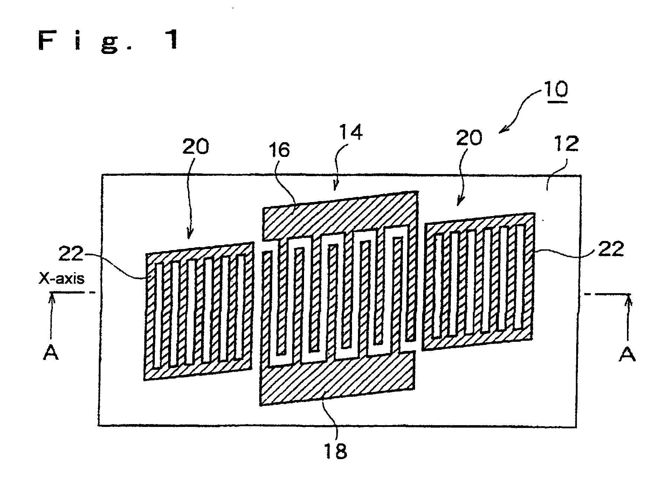

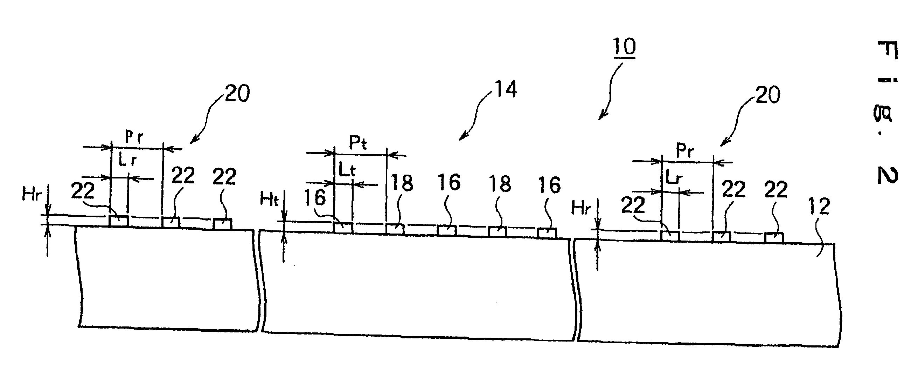

Fig. 1 is a front view of an embodiment of a surface acoustic wave (SAW) device according to the present invention, and Fig. 2 is a schematic sectional view along line A-A in Fig. 1.

As shown in the drawings, in a SAW device **10** which becomes an SAW resonator, the in-plane Z'-rotated ST cut quartz crystal plate **12** is prepared as a base substrate. Then, an IDT electrode **14** is provided in the central area of the surface of crystal plate **12**. The IDT electrode **14** comprises one pair of anode electrodes **16** and cathode electrodes **18** each consisting of comb teeth, and the IDT electrode **14** is constructed by arranging the anode and cathode comb teeth alternately and in parallel to each other. A surface acoustic wave is excited due to the piezoelectric effect of the crystal plate **12** by applying a high-frequency electric field between the two electrodes **16** and **18** arranged in this manner.

Plural reflectors **20** are provided on both sides of the IDT electrode **14** on the principal surface of the crystal plate **12**. The reflectors **20** take a form of parallel multiple short-circuited electrodes **22** having a given width, and the reflection of a Rayleigh wave in the surface acoustic wave generated by the IDT electrodes **14** is performed by the multiple short-circuit electrodes **22**.

The anode electrodes **16** and the cathode electrodes **18** in the IDT electrodes **14** as well as the short-circuit electrodes **22** in the reflectors 20 are arrayed in the X'-axis direction on the crystal plate **12**, and the reflection of Rayleigh wave caused by the short-circuit electrodes **22** is performed at positions of both edges of the electrodes.

In the SAW device **10** using the in-plane Z'-rotated ST cut quartz crystal plate as crystal plate **12**, as shown in Fig. 2, the width and the pitch of the anode electrodes **16** and the cathode electrodes **18** in the IDT electrode **14** are defined as Lₜ and Pₜ, respectively, the width and the pitch of the short-circuit electrodes **22** are defined as Lᵣ and Pᵣ, respectively, the thickness of the anode electrodes **16** and the cathode electrodes **18** is defined as Hₜ, and the thickness of short-circuit electrodes **22** is defined as Hᵣ.

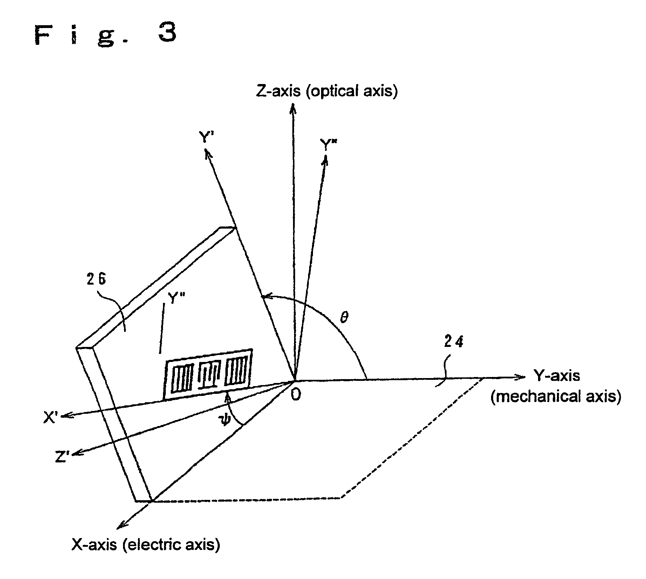

Fig. 3 is an illustrative diagram of the crystal plate **12** used for the SAW device **10** .

As shown in Fig. 3, the crystal axes of quartz are defined as the electrical axis (X-axis), mechanical axis (Y-axis) and optical axis (Z-axis). A quartz crystal plate called an ST cut is cut off along new coordinate axes (X, Y', Z') of a quartz crystal plate **26** obtained by rotating a quartz crystal Z plate **24** with an Euler angle (φ, θ, ψ) = (0, 0, 0) by θ = 113 - 135° around the electrical axis (X-axis). A piezoelectric substrate which is prepared by further rotating the quartz crystal plate by ψ = ± (40 - 49) degree around the Z'-axis of the quartz crystal plate **26** so that the propagation direction of the surface acoustic wave becomes the direction of the X'-axis defined by this angle ψ is called herein "in-plane Z'-rotated ST cut quartz crystal plate" and is used as crystal plate **12**. It has been known that such crystal plate **12** has extremely small frequency change to temperature change.

It was found by the investigation of the inventors that the reflection coefficient in the SAW device **10** using such in-plane Z'-rotated ST cut quartz crystal plate as crystal plate **12** is different from that of the SAW device using the conventional ST cut quartz crystal resonator.

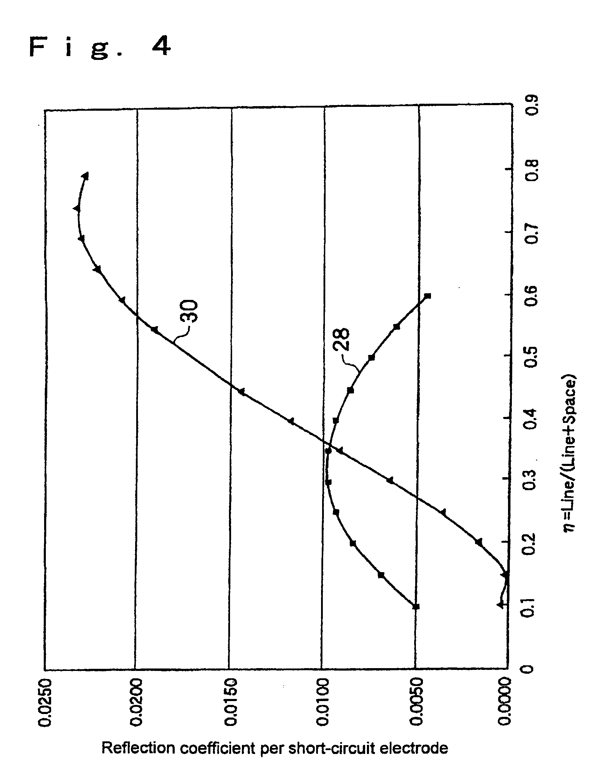

Fig. 4 is a graph for comparing the reflection coefficient of the SAW device according to the present invention and that of a conventional SAW device. In Fig. 4, the value of Lₜ/Pₜ (= Lᵣ/Pᵣ, called η hereafter) is shown on the horizontal axis and the reflection coefficient per short-circuit electrode is shown on the vertical axis.

Details of the crystal plate 12 of the SAW device of this embodiment are: θ = 133°, ψ = 43.4° and H/λ = 0.035. On the other hand, details of the ST cut quartz crystal plate of the conventional SAW device are: θ = 133°, ψ = 0° and H/λ = 0.03.

Reference numeral **28** in Fig. 4 denoted the characteristics of the SAW device of the present embodiment thus set up, and the characteristic of the conventional SAW device is indicated by **30**. The characteristic of the conventional SAW device indicates a tendency that the reflection coefficient increases with an increase in η. By contrast, in the device of the present embodiment, such a phenomenon that the reflection coefficient increases with an increase in η is not confirmed; rather the reflection coefficient assumes a maximum at a value of η in the vicinity of 0.3 and is lower at values of η greater or smaller than this value.

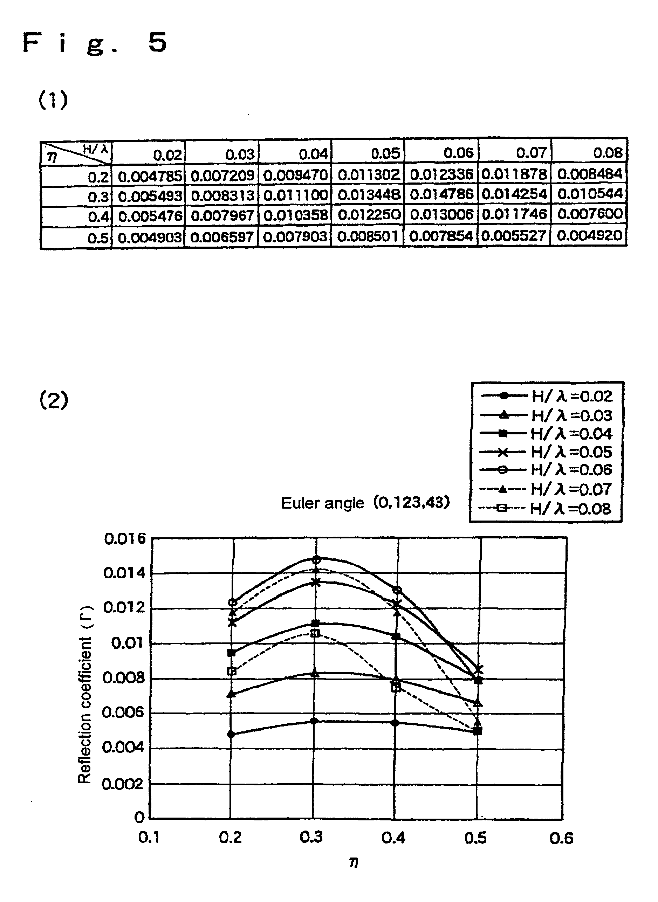

Fig. 5 shows the relationship between the reflection coefficient and /λ in the SAW device according to the present invention, Fig. 5(1) shows a table of calculation results, and Fig. 5(2) is a graph based on the calculation results in Fig. 5(1). The η values of the data shown in this Fig. 5(1) are obtained from the fact that the optimum value from the average of η values maximizing the reflection coefficient at each H/λ value is 0.32. Moreover, electrodes are more micro-fined in the SAW device for obtaining a high resonance frequency, therefore errors relative to the electrode width of manufacture dispersion increases. As a present manufacturing error, for example, if the sound speed is taken as 3,250 m/sec, the pitch Pₜ at an oscillation frequency zone of about 1 GHz is about 1.625µm, and the manufacturing dispersion of electrode width at this time is about ±0.16 µm. It becomes ±0.1 if converted to η.

Accordingly, it was found that the reflection coefficient takes the maximum when η of the crystal plate **12** is in the range of 0.32 ± 0.1.

From the above follows that, if the electrode widths and the pitches of the IDT electrodes **14** and reflectors **20** or either one thereof are set in the range where η is 0.32 ± 0.1 in the SAW device **10** using the in-plane Z'-rotated ST cut quartz crystal plate as crystal plate **12**, this enables improving the reflection coefficient, allows a decrease of the electrode number of the short-circuit electrodes **22** and the miniaturization of the SAW device **10**.

Fig. 4 shows that a range of η which maximizes the reflection coefficient exists in the SAW device **10** of this embodiment, but it is shown in Fig. 5 that the reflection coefficient is improved in terms of not only the η values but also the fluctuation of the H/λ values.

Namely, in Fig. 5, for the crystal plate **12** of the SAW device of the present embodiment with θ = 123°, and ψ = 43° the reflection coefficient is shown for each of 7 H/λ values in the range from 0.02 to 0.08. As shown in Fig. 5 (2), the reflection coefficient is maximized when H/λ is 0.06, and the reflection coefficient lowers in case that H/λ deviates from this value.

Moreover, it is clarified from Fig. 5 that the reflection coefficient is maximum at H/λ = 0.06 even if the H/λ values maximizing the reflection coefficient at η = 0.2, 0.3 and 0.4 calculated to their mean value are taken. Furthermore, it is clarified from Fig. 5(2), a decrease in the reflection coefficient is large in the range where H/λ is more than 0.06 ± 0.01, therefore H/λ = 0.06 ± 0.01 is also the optimum value.

It was confirmed that the reflection coefficient also increases with an increase in H/λ in the SAW device using a conventional ST cut quartz crystal plate, but as shown in the graph of Fig. 5(2), it was clarified by the investigation of inventors that the reflection characteristics of the SAW device using the in-plane Z'-rotated ST cut quartz crystal plate are markedly different from those of a conventional ST cut quartz crystal plate even though the conventional ST cut quartz crystal plate is in a plane which is simply rotated .

Thus, the results shown in the graphs of Fig. 5 reveal that, if the electrode thickness of the IDT electrodes **14** and reflectors **20** or either one thereof are set in the range where H/λ is 0.06 ± 0.01 in the SAW device **10** using the in-plane Z'-rotated ST cut quartz crystal plate as crystal plate **12**, this enables improving the reflection coefficient, allowing a decrease of the electrode number of the short-circuit electrodes **22** and a miniaturization of the SAW device **10**.

If the design guidance is in agreement with the above-mentioned η value maximizing the reflection coefficient (0.32 ± 0.1) in addition to the optimum range of above-mentioned H/λ value, the reflection coefficient can be further increased.

## Claims

1. A surface acoustic wave device having one or more pairs of IDT electrodes (14) for exciting a Rayleigh wave and one or more reflectors (20) for trapping the Rayleigh wave arranged on the principal surface of an in-plane rotated ST cut quartz crystal plate (12) existing at a Euler angle (0, 113 - 135, ±(40 - 49)), **characterized by** the fact that a ratio Lₜ/Pₜand/or a ratio Lᵣ/Pᵣ is less than 0.5, wherein Lₜ and Pₜ are the width and pitch of the IDT electrodes (14), respectively, and Lᵣ and Pᵣ are the width and pitch of the reflectors (20), respectively.

2. The device of claim 1, **characterized by** the fact that Lₜ/Pₜ is 0.32 ± 0.1.

3. The device of any one of the preceding claims, **characterized by** the fact that Hₜ/2Pₜ is 0.06 ± 0.01, wherein Hₜ is the thickness of the IDT electrodes (14).

4. The device of any one of the preceding claims, **characterized by** the fact that Lᵣ/Pᵣ is 0.32 ± 0.1.

5. The device of any one of the preceding claims, **characterized by** the fact Hᵣ/2Pᵣ is 0.06 ± 0.01, wherein H, is the thickness of the reflectors (20).

## Patentansprüche

1. Akustische Oberflächenwellenvorrichtung mit einem oder mehreren Paaren IDT-Elektroden (14) zum Anregen einer Rayleigh-Welle und einem oder mehreren Reflektoren (20) zum Einfangen der Rayleigh-Welle, die auf der Hauptoberfläche einer in der Ebene rotierten ST-Schnitt-Quarzkristallplatte (12) mit einem Euler-Winkel von (0, 113 bis 135, ±(40 bis 49)), **gekennzeichnet durch** die Tatsache, dass ein Verhältnis Lₜ/Pₜ und/oder ein Verhältnis Lᵣ/Pᵣ kleiner als 0,5 ist, wobei Lₜ bzw. Pₜ die Breite bzw. Teilung der IDT-Elektroden (14) und Lᵣ bzw. Pᵣ die Breite bzw. Teilung der Reflektoren (20) sind.

2. Vorrichtung nach Anspruch 1, **gekennzeichnet durch** die Tatsache, dass Lₜ/Pₜ 0,32 ± 0,1 beträgt.

3. Vorrichtung nach einem der vorigen Ansprüche, **gekennzeichnet durch** die Tatsache, dass Hₜ/2Pₜ 0,06 ± 0,01 beträgt, wobei Hₜ die Dicke der IDT-Elektroden (14) ist.

4. Vorrichtung nach einem der vorigen Ansprüche, **gekennzeichnet durch** die Tatsache, dass Lᵣ/Pᵣ 0,32 ± 0,1 beträgt.

5. Vorrichtung nach einem der vorigen Ansprüche, **gekennzeichnet durch** die Tatsache, dass Hᵣ/2Pᵣ 0,06 ± 0,01 beträgt, wobei H, die Dicke der Reflektoren (20) ist.

## Revendications

1. Dispositif à ondes acoustiques de surface ayant une paire ou plusieurs paires d'électrodes (14) IDT pour exciter une onde de Rayleigh et un réflecteur (20) ou plusieurs réflecteurs (20) pour piéger l'onde de Rayleigh disposés sur la surface principale d'une lame (12) de cristal de quartz à coupe ST tournée dans le plan, sortant sous un angle d'Euler (0,113 - 135 ± (40 - 49)), **caractérisé par le fait qu'**un rapport Lₜ/Pₜ et/ou un rapport Lᵣ/Pᵣ est inférieur à 0,5, Lₜ et Pₜ étant la largeur et le pas des électrodes (14) IDT respectivement et Lᵣ et Pᵣ étant la largeur et le pas des réflecteurs (20) respectivement.

2. Dispositif suivant la revendication 1, **caractérisé par le fait que** Lₜ/Pₜ est égal à 0,32 ± 0,1.

3. Dispositif suivant l'une quelconque des revendications précédentes, **caractérisé par le fait que** Hₜ/2Pₜ est égal à 0,06 ± 0,01, Hₜ étant l'épaisseur des électrodes (14) IDT.

4. Dispositif suivant l'une quelconque des revendications précédentes, **caractérisé par le fait que** Lᵣ/Pᵣ est égal à 0,32 ± 0,1.

5. Dispositif suivant l'une quelconque des revendications précédentes, **caractérisé par le fait que** Hᵣ/2Pᵣ est égal à 0,06 ± 0,01 Hᵣ étant l'épaisseur des réflecteurs (20).
